# EUROPÄISCHE PATENTANMELDUNG

(11) **EP 0 920 059 A2**
(43) Veröffentlichungstag der Anmeldung: **02.06.1999**
(21) Anmeldenummer: 98119158.8
(22) Anmeldetag: 09.10.1998
(51) Int. Cl.: H01L 27/108, H01L 21/8242

(54) **Speicherzellenanordnung und Verfahren zu deren Herstellung**

(30) Priorität: 28.11.1997 DE 19752968
(71) Anmelder: SIEMENS AKTIENGESELLSCHAFT, 80333 München (DE)
(72) Erfinder: Bertagnolli, Emmerich, Prof., 80799 München (DE); Beckmann, Gustav, Dr., 01471 Radeburg (DE); Bianco, Michael, Dr., 81737 München (DE); Klose, Helmut, Dr., New York 12603 (US)

(57) **Zusammenfassung**

In einer Speicherzellenanordnung mit Speicherzellen, in denen eine elektrische Verbindung zwischen polykristallinem Halbleitermaterial einer Kondensatorelektrode (14) und einem monokristallinen Halbleitergebiet (19) besteht, werden im Bereich der elektrischen Verbindung zwischen dem polykristallinen Halbleitermaterial und dem monokristallinen Halbleitergebiet Inseln (13) aus amorphem Material angeordnet. Die Inseln (13) werden insbesondere durch thermisches Aufbrechen einer durch thermische Oxidation gebildeten amorphen Schicht erzeugt. Die Speicherzellenanordnung ist insbesondere eine DRAM-Anordnung mit einem Grabenkondensator.

## Beschreibung

In Speicherzellenanordnungen, insbesondere in DRAM-Anordnungen wird Information in Form von elektrischen Ladungen in einzelnen Speicherzellen abgespeichert. Die elektrische Ladung wird dabei vielfach in Speicherkondensatoren gespeichert. Dabei bleibt die Ladung nur begrenzte Zeit in dem Speicherkondensator erhalten. In heutigen DRAM-Anordnungen beträgt die Haltezeit in einem Speicherkondensator etwa 2 bis 3 Sekunden. Um die gespeicherte Information länger zu erhalten, wird diese periodisch aufgefrischt (sogenannter refresh).

Es hat sich gezeigt, daß einzelne Speicherzellen in Speicherzellenanordnungen stark schwankende Haltezeiten aufweisen. Das bedeutet, daß die Haltezeit in diesen Speicherzellen zwischen sehr kurzen Werten, zum Beispiel 10 Millisekunden, und üblichen Haltezeiten von 2 bis 3 Sekunden schwankt. Dieser Fehler, der auch als variable retention time failure bezeichnet wird, ist nicht vorhersehbar.

Der Erfindung liegt das Problem zugrunde, eine Speicherzellenanordnung anzugeben, bei der Schwankungen in der Haltezeit von gespeicherter Ladung reduziert sind. Darüber hinaus soll ein Herstellverfahren für eine derartige Speicherzellenanordnung angegeben werden.

Dieses Problem wird erfindungsgemäß gelöst durch eine Speicherzellenanordnung nach Anspruch 1 sowie durch ein Verfahren zu deren Herstellung nach Anspruch 6. Weitere Ausgestaltungen der Erfindung gehen aus den übrigen Ansprüchen hervor.

In einer Speicherzellenanordnung mit Speicherzellen, in denen eine elektrische Verbindung zwischen polykristallinem Halbleitermaterial einer Kondensatorelektrode und einem monokristallinen Halbleitergebiet besteht, sind im Bereich der elektrischen Verbindung zwischen dem polykristallinen Halbleitermaterial und dem monokristallinen Halbleitergebiet Inseln aus amorphem Material angeordnet. Diese Inseln aus amorphem Material stabilisieren die Grenzfläche zwischen dem monokristallinen Halbleitergebiet und dem polykristallinen Halbleitermaterial der Kondensatorelektrode. Dadurch wird vermieden, daß sich während des Herstellungsprozesses insbesondere bei Temperschritten, die Grenzfläche zwischen dem polykristallinen Halbleitermaterial und dem monokristallinen Halbleitergebiet dadurch verändert, daß einerseits epitaktisches Wachstum ausgehend von der Oberfläche des monokristallinen Halbleitergebiets in das polykristalline Halbleitermaterial hinein und andererseits Kornwachstum aus dem polykristallinen Halbleitermaterial in das monokristalline Halbleitergebiet hinein auftritt.

Vorzugsweise sind die Inseln im Bereich der elektrischen Verbindung flächig in einem unregelmäßigen Gitter angeordnet.

Die Gestalt der Inseln kann vielfältig sein. Insbesondere sind die Inseln kugelförmig, ellipsoidförmig, rotationsellipsoidförmig oder von unregelmäßiger Gestalt. Insbesondere können die verschiedenen Inseln unterschiedlich gestaltet sein.

Die Erfindung geht von folgenden Überlegungen aus: Der variable retention time failure-Effekt wird in Speicherzellen beobachtet, in denen eine elektrische Verbindung zwischen einem monokristallinen Halbleitergebiet und polykristallinem Halbleitermaterial einer Kondensatorelektrode besteht. Er wird insbesondere beobachtet bei Speicherzellen, in denen in einem monokristallinen Halbleitersubstrat ein Auswahltransistor angeordnet ist, dessen eines Source-/Drain-Gebiet mit einer in einem Graben angeordneten Kondensatorelektrode aus polykristallinem Halbleitermaterial in elektrischer Verbindung steht. Er tritt auch bei Speicherzellen mit einem Stapelkondensator auf.

Untersuchungen haben gezeigt, daß Speicherzellen mit variable retention time failure-Effekt in dem monokristallinen Halbleitergebiet Kristallstörungen zeigen, die von der Grenzfläche zwischen dem monokristallinen Halbleitergebiet zum polykristallinen Halbleitermaterial ausgehen. Die Störungen werden als Folge der instabilen Grenzflächen zwischen dem polykristallinem Halbleitermaterial und dem monokristallinen Halbleitergebiet gesehen.

Erfindungsgemäß sind zwischen dem polykristallinen Halbleitermaterial und dem monokristallinen Halbleitergebiet Inseln aus amorphem Material angeordnet. Diese Inseln bewirken eine mechanische Spannung sowohl auf die Oberfläche des monokristallinen Halbleitergebietes als auch auf die Oberfläche des polykristallinen Halbleitermaterials. Diese mechanische Spannung auf die besagten Oberflächen verhindert bei Temperprozessen epitaktisches Wachstum ausgehend von der Oberfläche des monokristallinen Halbleitergebietes und Kornwachstum ausgehend von dem polykristallinen Halbleitermaterial. Durch das Kornwachstum ausgehend von dem polykristallinen Halbleitermaterial wird die im polykristallinen Halbleitermaterial vorliegende Störung des Kristallgitters in das monokristalline Halbleitergebiet übertragen. Auch das epitaktische Wachstum ausgehend von der Oberfläche des monokristallinen Halbleitergebietes in das polykristalline Halbleitermaterial hinein bewirkt in dem monokristallinen Halbleitergebiet Störungen des Kristalls. Diese Störungen, die unter anderem zu Versetzungen führen können, werden in der erfindungsgemäßen Speicherzellenanordnung durch das Vorsehen der Inseln aus amorphem Material vermieden.

Gleichzeitig stellen die Inseln aus amorphem Material zwischen dem polykristallinen Halbleitermaterial und dem monokristallinen Halbleitergebiet einen elektrischen Kontakt sicher, da Ladungsträger zwischen den Inseln aus amorphem Material hindurch von dem polykristallinen Halbleitermaterial in das monokristalline Halbleitergebiet gelangen können. Darüber hinaus ist eine Diffusion von Dotierstoff zwischen dem polykristallinen Halbleitermaterial und dem monokristallinen Halbleitergebiet möglich.

Für die Inseln aus amorphem Material eignet sich sowohl isolierendes Material, insbesondere SiO₂ oder Si₃N₄, als auch leitendes Material, insbesondere Wolfram oder ein anderes hochschmelzendes Metall.

Das monokristalline Halbleitergebiet ist insbesondere Teil eines Halbleitersubstrats, das mindestens im Bereich der elektrischen Verbindung monokristallines Silizium aufweist. Als Halbleitersubstrat ist unter anderem eine monokristalline Siliziumscheibe oder eine monokristalline Siliziumschicht eines SOI-Substrates geeignet.

Die Inseln aus amorphem Material werden vorzugsweise aus Oxid, insbesondere aus Siliziumoxid, gebildet.

Bei der Herstellung der Speicherzellenanordnung wird vorzugsweise auf die Oberfläche des monokristallinen Halbleitergebietes im Bereich der elektrischen Verbindung eine amorphe Schicht vorgegebener Dicke aufgebracht. Darauf wird polykristallines Halbleitermaterial aufgebracht. Dabei stellt die amorphe Schicht sicher, daß das polykristalline Halbleitermaterial polykristallin aufwächst. Zur Bildung der Inseln aus amorphem Material wird vorzugsweise ein Temperschritt durchgeführt, bei dem die amorphe Schicht in die Inseln zerfällt.

Eine derartige Bildung von Oxidinseln aus einer zuvor durchgehenden Oxidschicht durch einen Temperprozeß ist zwar im Zusammenhang mit Bipolartransistoren bereits aus H. Schaber et al, IEDM 1987, Seiten 170 bis 173, bekannt. Dabei wird ein derartiger Temperschritt verwendet, um eine sogenannte native Oxidschicht oder Lageroxidschicht, die sich an freiliegenden Siliziumoberflächen unkontrollierbar bildet und die bei Bipolartransistoren an der Oberfläche des Emitters zu erhöhten Widerstandswerten zwischen dem Emitter und dem Emitteranschluß führen, aufzubrechen. Durch das thermische Aufbrechen der Lageroxidschicht bei Bipolartransistoren wird der Emitterwiderstand verbessert. Ein Hinweis auf den Einfluß von Inseln aus amorphem Material auf das Entstehen von Störungen in monokristallinem Halbleitermaterial findet sich in H. Schaber et al, IEDM 1987, Seiten 170 bis 173, jedoch nicht.

Das monokristalline Halbleitergebiet ist insbesondere ein Source-/Drain-Gebiet eines Auswahltransistors. Die Kondensatorelektrode ist insbesondere in einem Graben angeordnet, der in ein Halbleitersubstrat geätzt ist, und Teil eines sogenannten Grabenkondensators, der neben der Kondensatorelektrode ein Kondensatordielektrikum und als Gegenelektrode einen dem Graben benachbarten Teil des Halbleitersubstrats aufweist. Die Kondensatorelektrode kann auch an der Oberfläche des Halbleitersubstrats, in dem Auswahltransistoren angeordnet sind, angeordnet sein und Teil eines Stapelkondensators sein.

Vorzugsweise sind die Inseln so angeordnet, daß das Verhältnis aus dem Abstand zwischen benachbarten Inseln zum Durchmesser der Inseln maximal 10:1, vorzugsweise maximal zwischen 2:1 und 1:1, beträgt. Diese Anordnung stellt sicher, daß die durch die Inseln verursachten Spannungen gleichmäßig über die Oberfläche des monokristallinen Halbleitergebiets im Bereich der elektrischen Verbindung verteilt sind und so über den gesamten Bereich die Ausbildung von Störungen verhindern.

Vorzugsweise weisen die Inseln parallel zur Oberfläche des monokristallinen Halbleitergebiets Abmessungen im Bereich zwischen 0,5 und 50 nm auf. Die Abstände zwischen benachbarten Inseln betragen ebenfalls 0,5 bis 50 nm. Senkrecht zur Oberfläche des monokristallinen Halbleitergebietes weisen sie eine Dicke zwischen 0,5 nm und 15 nm auf. Als Oberfläche des monokristallinen Halbleitergebietes wird dabei jeweils die Oberfläche betrachtet, an der die Inseln angeordnet sind. Diese Oberfläche kann insbesondere im oberen Bereich einer Wand eines Grabens, in dem die Kondensatorelektrode angeordnet ist, liegen und senkrecht zu einer Hauptfläche eines Halbleitersubstrats ausgerichtet sein.

Gemäß einer bevorzugten Ausgestaltung weisen die Inseln parallel zur Oberfläche des monokristallinen Halbleitergebiets Abmessungen im Bereich zwischen 8 und 20 nm auf. Die Abstände zwischen benachbarten Inseln betragen etwa 12 nm. Senkrecht zur Oberfläche des monokristallinen Halbleitergebietes weisen sie eine Dicke von etwa 8 nm auf.

Bei der Herstellung der Speicherzellenanordnung wird die amorphe Schicht vorzugsweise durch thermische Oxidation gebildet. Um die kontrollierte Herstellung der amorphen Schicht in einer vorgegebenen Dicke sicherzustellen, wird dabei eine vorgegebene Temperatur und Zeit in oxidierender Atmosphäre eingehalten. Die oxidierende Atmosphäre kann dabei sowohl durch Sauerstoff in einem Restgas, Sauerstoff in der Atmosphäre, insbesondere in Luft, oder durch ein gezielt zugegebenes Reaktionsgas mit Sauerstoff realisiert werden. Im Hinblick auf die Kontrollierbarkeit der Schichtdicke der amorphen Schicht ist es dabei vorteilhaft, die thermische Oxidation bei einer relativ niedrigen Temperatur, insbesondere im Bereich zwischen 500 und 625°C durchzuführen.

Das Tempern zur Bildung der Inseln erfolgt vorzugsweise im Bereich zwischen 950 und 1150°C. Dabei wird ausgenutzt, daß bei derartig hohen Temperaturen spontan Inseln gebildet werden, deren Durchmesser und Abstand durch die Dicke der amorphen Schicht vorgebbar ist.

Die Inseln aus amorphem Material können auch auf andere Weise, zum Beispiel durch Abscheidung einer amorphen Schicht, die mit Hilfe einer statistisch gebildeten Maske oder mit Hilfe von Elektronenstrahllithographie strukturiert wird, gebildet werden.

Im folgenden werden Ausführungsbeispiele der Erfindung, die in den Figuren dargestellt sind, näher erläutert.

Die Darstellungen in den Figuren sind nicht maßstäblich.
- Figur 1: zeigt ein monokristallines Halbleitergebiet mit einer amorphen Schicht und einer polykristallinen Halbleiterschicht.
- Figur 2: zeigt das monokristalline Halbleitergebiet mit der polykristallinen Halbleiterschicht nach Bildung von Inseln durch Tempern.
- Figur 3: zeigt einen Schnitt durch eine Speicherzellenanordnung mit Speicherzellen, die jeweils einen Auswahltransistor und einen Grabenkondensator aufweisen.

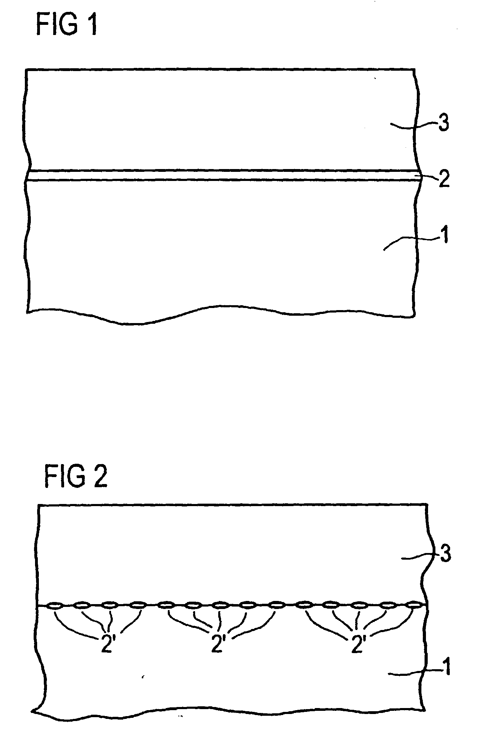

Auf einer Oberfläche eines monokristallinen Halbleitergebietes 1, das Teil einer monokristallinen Siliziumscheibe oder einer monokristallinen Siliziumschicht, die an der Oberfläche einer vergrabenen isolierenden Schicht eines SOI-Substrats angeordnet ist, ist, wird eine amorphe Schicht 2 und darauf eine Polysiliziumschicht 3 aufgebracht (siehe Figur 1). Die amorphe Schicht 2 wird kontrolliert in einer Dicke von 0,5 nm aus SiO₂ gebildet.

Zur Bildung der amorphen Schicht 2 wird zunächst die Oberfläche des monokristallinen Halbleitergebietes 1 durch eine Ätzung mit Flußsäure gereinigt. Dabei wird natives Oxid (auch Lageroxid genannt), das an der freiliegenden Halbleiteroberfläche unbeabsichtigt und unkontrolliert aufgewachsen ist, vollständig entfernt. Anschließend wird das monokristalline Halbleitergebiet 1 mit der freigeätzten Oberfläche in einen Ofen eingebracht. Beim Einbringen in den Ofen ist die freigelegte Halbleiteroberfläche der Umgebungsluft ausgesetzt, wobei sich erneut natives Oxid bildet. Die Dicke des gebildeten nativen Oxides ist abhängig von der Dotierung des monokristallinen Halbleitergebietes 1 , von der Kristallorientierung und von der Dauer des Beladungsvorganges des Ofens. Beträgt die Dotierung des monokristallinen Halbleitergebietes 10¹⁷ cm⁻³ Arsen und die Dauer der Beladung des Ofens eine Stunde, so bildet sich bei einer 〈100〉-Orientierung des monokristallinen Halbleitergebietes 1 natives Oxid in einer Schichtdicke von 0,3 nm. Das Einfahren in den Ofen erfolgt bei einer möglichst niedrigen Temperatur von 500°C.

Nach dem Beladen des Ofens wird der Ofen geschlossen und die amorphe Schicht 2 in ihrer Enddicke durch eine genaue Temperaturkontrolle und Zeitdauer gebildet. Bei 500°C und sechs Minuten Oxidationszeit bildet sich die amorphe Schicht 2 mit einer Gesamtdicke von 0,5 nm. Teil der amorphen Schicht 2 ist auch das während des Beladens des Ofens gebildete native Oxid.

Als oxidierende Atmosphäre im Ofen bei der Bildung der amorphen Schicht 2 dient die Umgebungsatmosphäre, die nach dem Schließen des Ofens verbleibt und die Sauerstoff enthält.

Nach Bildung der amorphen Schicht 2 in der vorgegebenen Dicke wird die oxidierende Atmosphäre in dem Ofen abgepumpt. Der Ofen wird auf eine für die nachfolgende Abscheidung der Polysiliziumschicht 3 erforderliche Abscheidetemperatur von 625°C gebracht. Die Abscheidung erfolgt unter Verwendung eines Silizium enthaltenden Prozeßgases, z. B. Silan. Das Prozeßgas bei der Abscheidung enthält keinen Sauerstoff, so daß die Dicke der amorphen Schicht 2 unverändert bleibt. Die Polysiliziumschicht 3 wird in einer Dicke von 300 nm abgeschieden.

Durch Tempern im Temperaturbereich zwischen 950°C und 1150°C wird die bis dahin durchgehende amorphe Schicht 2 aufgebrochen und es bilden sich daraus Inseln 2' aus amorphem Material. Die Inseln 2' sind zwischen der Oberfläche des monokristallinen Halbleitergebietes 1 und der Polysiliziumschicht 3 flächig angeordnet. Die einzelnen Inseln 2' sind kugelförmig, ellipsoidförmig oder von unregelmäßiger Gestalt. Ferner ist die Anordnung von ungleichmäßiger Bedeckung.

Wird die amorphe Schicht in einer Schichtdicke von 0,5 nm gebildet und der Temperschritt bei 1100°C fünf Sekunden durchgeführt, so ergeben sich Inseln 2', die im wesentlichen ellipsoidförmig sind und die Abmessungen parallel zur Oberfläche des monokristallinen Halbleitergebietes 1 von 8 nm bis 20 nm aufweisen, wobei der Abstand zwischen benachbarten Gebieten 2' 12 nm beträgt. Die Dicke der Inseln 2' senkrecht zur Oberfläche des monokristallinen Gebietes 1 beträgt 8 nm. Diese Anordnung der Inseln 2' stellt einerseits eine thermodynamisch stabile Grenzfläche zwischen dem monokristallinen Halbleitergebiet 1 und der Polysiliziumschicht 3 sicher. Andererseits erlaubt sie eine elektrische Verbindung mit einem definierten elektrischen Kontakt zwischen der Polysiliziumschicht 3 und dem monokristallinen Halbleitergebiet 1.

Zwischen der Abscheidung der Polysiliziumschicht 3 und dem Temperschritt zur Bildung der Inseln 2' liegen in der Regel eine Vielzahl anderer Prozeßschritte. Der Temperschritt zur Bildung der Inseln 2' kann insbesondere gleichzeitig mit einem Temperschritt zur Aktivierung und/oder Diffusion von Dotierstoffen durchgeführt werden.

Die oxidierende Atmosphäre zur Bildung der amorphen Schicht 2 kann auch durch eine gezielte Sauerstoffzufuhr gebildet werden. Dazu kann insbesondere ein Ofen mit einer Vakuumschleuse verwendet werden, in den nach Einbringen des monokristallinen Halbleitergebiets Sauerstoff eingespeist wird. Ferner kann ein Ofen verwendet werden, in dem die Oberfläche des monokristallinen Halbleitergebiets 1 zur Entfernung des unkontrolliert aufgewachsenen nativen Oxids freigeätzt wird. Durch gezielte Sauerstoffzufuhr wird anschließend die amorphe Schicht 2 kontrolliert aufgewachsen. Als Ofen ist sowohl ein Ofen geeignet, in dem die Bildung der amorphen Schicht 2 und der Polysiliziumschicht 3 in ein und derselben Kammer gebildet werden als auch ein Ofen mit mehreren Kammern. Die amorphe Schicht 2 kann auch bei derselben Temperatur gebildet werden, bei der die Polysiliziumschicht 3 abgeschieden wird. In diesem Fall ist allerdings eine sehr genaue Kontrolle der Oxidationsdauer und der Sauerstoffzufuhr erforderlich.

Zur Herstellung einer Speicherzellenanordnung mit Speicherzellen, die jeweils einen Grabenkondensator und einen Auswahltransistor aufweisen, werden in einem p-dotierten Siliziumsubstrat 10 mit 〈100〉-Orientierung durch maskiertes anisotropes Ätzen Gräben 11 mit einer Tiefe von 8 µm gebildet.

An der Oberfläche der Gräben 11 wird ein Kondensatordielektrikum 12 gebildet. Das Kondensatordielektrikum 12 wird als Dreifachschicht aus einer ersten SiO₂-Schicht, einer Si₃N₄-Schicht und einer zweiten SiO₂-Schicht in einer Gesamtdicke von 5 nm gebildet.

Das Kondensatordielektrikum 12 wird jeweils im oberen Bereich einer Flanke 11' der Gräben 11 entfernt, so daß im oberen Bereich der Flanke 11' die Oberfläche des monokristallinen Siliziumsubstrats 10 freiliegt. Auf der freiliegenden Oberfläche des monokristallinen Siliziumsubstrats 10 im oberen Bereich der Flanke 11' wird, wie anhand von Figur 1 und 2 erläutert, eine amorphe Schicht aus SiO₂ in einer Dicke von 0,5 nm kontrolliert erzeugt, aus der im weiteren Prozeßverlauf Inseln 13 aus amorphem Material gebildet werden. Für die Bildung der amorphen Schicht aus SiO₂ gilt das im Zusammenhang mit Figur 1 und 2 Gesagte.

Durch Abscheiden einer dotierten Polysiliziumschicht werden nachfolgende Kondensatorelektroden 14 aus Polysilizium gebildet, die die Gräben 11 im wesentlichen auffüllen. Zwischen der Kondensatorelektrode 14 aus polykristallinem Silizium und dem monokristallinen Siliziumsubstrat 10 ist im oberen Teil der Flanke 11' die in kontrollierter Dicke gewachsene amorphe Schicht angeordnet. Damit wächst die Polysiliziumschicht, die die Kondensatorelektrode 14 bildet, kontrolliert polykristallin auf.

Nachfolgend wird in einem LOCOS-Prozeß oder in einem ShallowTrench-Isolation (STI)-Prozeß eine Isolationsstruktur 15 gebildet, die jeweils den oberen Teil der Flanken 11' von zwei benachbarten Gräben 11 umgibt.

Die Hauptfläche des monokristallinen Siliziumsubstrats 10 wird nachfolgend mit einem Gatedielektrikum 16 versehen, das durch thermische Oxidation in einer Schichtdicke von 12,5 nm gebildet wird.

Nachfolgend werden Wortleitungen 17 erzeugt, wobei zwischen zwei benachbarten Gräben 11 zwei Wortleitungen 17 angeordnet sind. Die Wortleitungen 17 werden mit einer Wortleitungsisolation 18 zum Beispiel aus SiO₂ umgeben.

Durch Implantation mit Phosphor und/oder Arsen werden zwischen den Wortleitungen 17 und dem benachbarten Graben 11 jeweils ein Source-/Drain-Gebiet 19 und zwischen den beiden Wortleitungen ein gemeinsames Source-/Drain-Gebiet 20 gebildet.

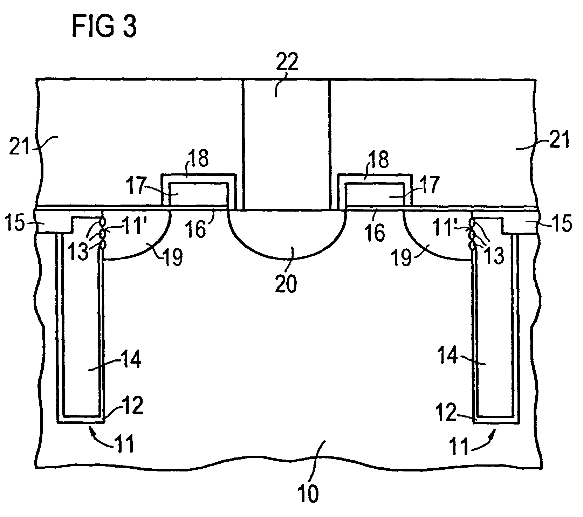

Es folgt ein Temperschritt bei 1100°C, fünf Sekunden, bei dem einerseits die Dotierstoffe der Source-/Drain-Gebiete 19, 20 aktiviert und diffundiert werden und bei dem andererseits durch Aufbrechen der amorphen Schicht, die an den Flanken 11' angeordnet ist, die Inseln 13 aus amorphem Material gebildet werden. Die Inseln 13 aus amorphem Material sind im wesentlichen ellipsoidförmig und weisen parallel zur Flanke 11' Abmessungen zwischen 8 nm und 20 nm auf. Senkrecht zur Flanke 11' weisen sie eine Dicke von etwa 8 nm auf. Der Abstand zwischen benachbarten Inseln 13 beträgt etwa 12 nm. Die Inseln 13 bewirken, daß die Grenzfläche zwischen der Kondensatorelektrode 14 und dem monokristallinen Source-/Drain-Gebiet 19 im Siliziumsubstrat 10 stabil ist und sich insbesondere keinerlei Störungen in das Source-/Drain-Gebiet 19, 20 und das Siliziumsubstrat 10 ausgehend von dieser Grenzfläche ausbilden. (Die Darstellung der Inseln 13 in Figur 3 ist schematisch und stark vergrößert. Real weist der dargestellte Schnitt eine Vielzahl von Inseln 13 auf.)

Nachfolgend wird die Speicherzellenanordnung in bekannter Weise fertiggestellt. Insbesondere wird eine Passivierungsschicht 21 abgeschieden, in der Bitleitungskontakte 22 zu dem gemeinsamen Source-/Drain-Gebiet 20 erzeugt werden.

Jede Speicherzelle in der Speicherzellenanordnung weist einen Grabenkondensator und einen Auswahltransistor auf. Der Grabenkondensator wird jeweils aus der Kondensatorelektrode 14, dem Kondensatordielektrikum 12 und dem umgebenden Substratmaterial, das p-dotiert ist, gebildet. Der Auswahltransistor wird jeweils aus den Source-/Drain-Gebieten 19, 20 und dem dazwischen angeordneten Gatedielektrikum 16 und der entsprechenden Wortleitung 17 gebildet. Die Kondensatorelektrode 14 ist mit einem der Source-/Drain-Gebiete 19 elektrisch verbunden, wobei im Bereich dieser elektrischen Verbindung Inseln 13 aus amorphem Material angeordnet sind.

## Patentansprüche

1. Speicherzellenanordnung mit Speicherzellen, in denen eine elektrische Verbindung zwischen polykristallinem Halbleitermaterial einer Kondensatorelektrode (14) und einem monokristallinen Halbleitergebiet (19) besteht,
bei der im Bereich der elektrischen Verbindung zwischen dem polykristallinen Halbleitermaterial (14) und dem monokristallinen Halbleitergebiet (19) Inseln (13) aus amorphem Material angeordnet sind.

2. Speicherzellenanordnung nach Anspruch 1,
bei der die Inseln (13) so angeordnet sind, daß das Verhältnis aus dem Abstand zwischen benachbarten Inseln (13) zum Durchmesser der Inseln (13) maximal 10:1 beträgt.

3. Speicherzellenanordnung nach Anspruch 1 oder 2,
- bei der die Kondensatorelektrode (14) Teil eines Speicherkondensators ist, der als Grabenkondensator ausgestaltet ist,
- bei der das monokristalline Halbleitergebiet (19) ein Source-/Drain-Gebiet eines Auswahltransistors ist, der in einem Halbleitersubstrat (10) angeordnet ist.

4. Speicherzellenanordnung nach einem der Ansprüche 1 bis 3,
- bei der das monokristalline Halbleitergebiet (19) mindestens im Bereich der elektrischen Verbindung monokristallines Silizium aufweist,
- bei der die Kondensatorelektrode (14) mindestens im Bereich der elektrischen Verbindung polykristallines Silizium aufweist,
- bei der die Inseln (13) SiO₂ aufweisen.

5. Speicherzellenanordnung nach einem der Ansprüche 1 bis 4, bei der die Inseln (13) parallel zur Oberfläche des monokristallinen Halbleitergebietes (19) Abmessungen im Bereich zwischen 0,5 und 50 nm und Abstände zwischen benachbarten Inseln (13) zwischen 0,5 und 50 nm aufweisen und senkrecht zur Oberfläche des monokristallinen Halbleitergebietes (19) eine Dicke von 0,5 nm bis 15 nm aufweisen.

6. Verfahren zur Herstellung einer Speicherzellenanordnung mit Speicherzellen, in denen eine elektrische Verbindung zwischen polykristallinem Halbleitermaterial einer Kondensatorelektrode und einem monokristallinen Halbleitergebiet gebildet wird,
- bei dem im Bereich der elektrischen Verbindung auf der Oberfläche des monokristallinen Halbleitergebietes (1) eine amorphe Schicht (2) in einer vorgegebenen Dicke gebildet wird,
- bei dem auf die amorphe Schicht (2) das polykristalline Halbleitermaterial (3) der Kondensatorelektrode aufgebracht wird,
- bei dem ein Temperschritt durchgeführt wird, bei dem aus der amorphen Schicht (2) Inseln (2') aus amorphem Material gebildet werden.

7. Verfahren nach Anspruch 6,
bei dem die Inseln (2') so gebildet werden, daß das Verhältnis aus dem Abstand zwischen benachbarten Inseln (2') zum Durchmesser der Inseln (2') maximal 10:1 beträgt.

8. Verfahren nach Anspruch 6 oder 7,
- bei dem die Oberfläche des monokristallinen Halbleitergebietes (1) durch eine Ätzung freigelegt wird,
- bei dem die amorphe Schicht (2) durch thermische Oxidation bei vorgegebener Temperatur und Oxidationszeit in oxidierender Atmosphäre gebildet wird,
- bei dem das polykristalline Halbleitermaterial (3) in einem Ofen abgeschieden wird, in dem zuvor die thermische Oxidation zumindest teilweise durchgeführt wird.

9. Verfahren nach Anspruch 8,
bei dem die thermische Oxidation bei einer geringeren Temperatur als die Abscheidung des polykristallinen Halbleitermaterials (3) durchgeführt wird.

10. Verfahren nach Anspruch 8 oder 9,
- bei dem das monokristalline Halbleitergebiet (1) mindestens im Bereich der elektrischen Verbindung Silizium aufweist,
- bei dem die Kondensatorelektrode mindestens im Bereich der elektrischen Verbindung polykristallines Silizium aufweist,
- bei dem die amorphe Schicht aus SiO₂ gebildet wird,
- bei dem die amorphe Schicht bei 500 bis 625°C und einer Oxidationsdauer von 4 bis 8 Minuten durch thermische Oxidation gebildet wird,
- bei dem das Tempern zur Bildung der Inseln (2') bei 950 bis 1150°C erfolgt.

11. Verfahren nach einem der Ansprüche 6 bis 10,
bei dem die Inseln (2') parallel zur Oberfläche des monokristallinen Halbleitergebietes (1) Abmessungen im Bereich zwischen 0,5 und 50 nm und Abstände zwischen benachbarten Inseln (2') im Bereich zwischen 0,5 und 50 nm aufweisen und senkrecht zur Oberfläche des monokristallinen Halbleitergebiets (1) eine Dicke im Bereich zwischen 0,5 nm und 15 nm aufweisen.

12. Speicherzellenanordnung mit Speicherzellen, in denen eine elektrische Verbindung zwischen polykristallinem Halbleitermaterial einer Kondensatorelektrode und einem monokristallinen Halbleitergebiet besteht, hergestellt nach einem Verfahren nach einem der Ansprüche 6 bis 11.
